# EUROPEAN PATENT APPLICATION

(11) **EP 2 624 434 A1**
(43) Date of publication of application: **07.08.2013**
(21) Application number: 11829197.0
(22) Date of filing: 28.09.2011
(51) Int. Cl.: H02N 2/00, B81B 3/00, H01L 41/113, H01L 41/18, H01L 41/22, H01L 41/24

(54) **VIBRATION POWER GENERATION ELEMENT AND VIBRATION POWER GENERATION DEVICE PROVIDED WITH SAME**

(30) Priority: 01.10.2010 JP 2010224154
(71) Applicant: Panasonic Corporation, Osaka 571-8501 (JP)
(72) Inventor: YAMAUCHI, Norihiro, Osaka 540-6207 (JP); OGAWA, Junya, Osaka 540-6207 (JP); MATSUSHIMA, Tomoaki, Osaka 540-6207 (JP); AIZAWA, Koichi, Osaka 540-6207 (JP)
(74) Representative: Appelt, Christian W.
(86) International application number: PCT/JP2011/072222
(87) International publication number: WO 2012/043644

(57) **Abstract**

A vibration power generation element includes a base substrate having a support portion and a cantilever portion, and a power generation unit for generating alternating current power in response to vibration of the cantilever portion. The power generation unit includes: a lower electrode formed on one surface side of the base substrate so as to overlap the cantilever portion; a first piezoelectric layer formed on an opposite side of the lower electrode from the cantilever portion; an intermediate electrode formed on an opposite side of the first piezoelectric layer from the lower electrode; a second piezoelectric layer formed on an opposite side of the intermediate electrode from the first piezoelectric layer; and an upper electrode formed on an opposite side of the second piezoelectric layer from the intermediate electrode.

## Description

### Technical Field

The present invention relates to a vibration power generation element for converting vibration energy into electric energy, and a vibration power generation device including the vibration power generation element.

### Background Art

In recent years, research and development have been undertaken in various locations into a vibration power generation element serving as a type of MEMS (Micro Electro Mechanical Systems) device, which is configured to convert vibration energy generated by peripheral vibration such as vehicle vibration or vibration caused by human movement into electric energy.

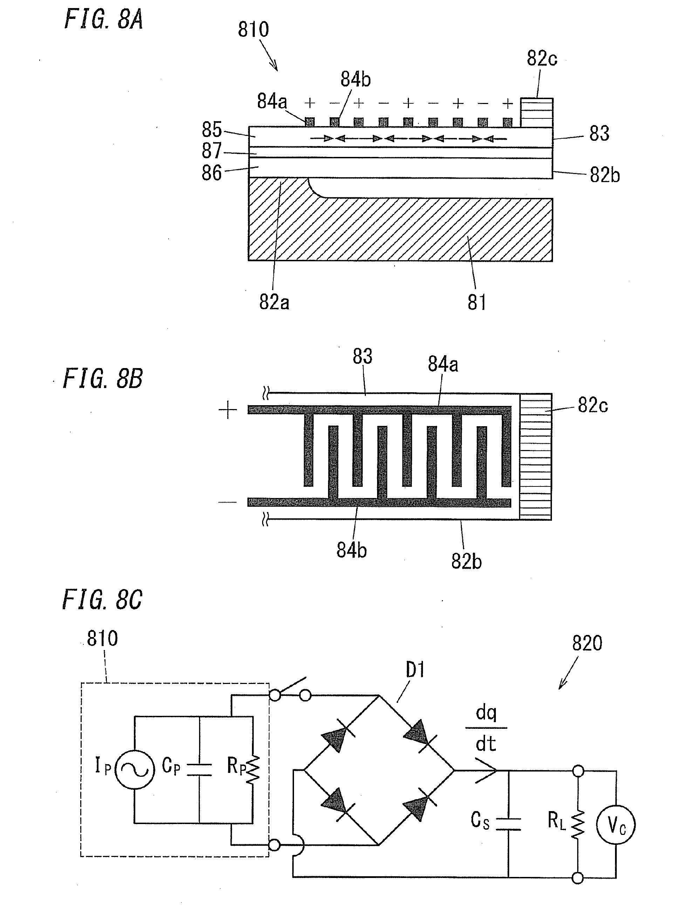

As shown in Fig. 8A, a conventional example of this type of vibration power generation element includes a cantilever portion (a flexible portion) 82b, a first end side of which is fixed to a support portion 82a of a base substrate 81 made of Si, supported such that a second end side of the cantilever portion is free to oscillate via a space formed relative to the base substrate 81, and a power generation unit 83 formed on the cantilever portion 82b and configured to generate alternating current power in response to vibration of the cantilever portion 82b (for example, Y.B. Jeon, et al, "MEMS Power Generator with Transverse Thin Film PZT", Sensors and Actuators A 122, 16-22, 2005 (to be referred to hereafter as "Document 1")).

In a vibration power generation element 810 shown in Fig. 8A, the cantilever portion 82b is configured to include a thin film 86 made of SiO₂ or Si₃N₄, and a diffusion prevention layer 87 (here, ZrO₂) formed on the thin film 86 to prevent diffusion of a charge from the power generation unit 83.

Further, the power generation unit 83 on the diffusion prevention layer 87 is constituted by a piezoelectric layer 85 made of PZT (Pb(Zr, Ti)O₃), and a pair of electrodes 84a, 84b made of Pt/Ti and formed on one surface side of the piezoelectric layer 85. Note that the piezoelectric layer 85 is constructed using a d₃₃ mode in which a deformation direction is orthogonal to an electric field direction, while the pair of electrodes 84a, 84b respectively take a comb shape when seen from above and are disposed at a predetermined interval so as to intermesh (see Fig. 8B). Furthermore, a weight portion 82c is provided in the vibration power generation element 810 on a second end side surface of the cantilever portion 82b to increase the oscillation of the cantilever portion 82b.

In the vibration power generation element 810, when the cantilever portion 82b oscillates due to vibration, the piezoelectric layer 85 of the power generation unit 83 is polarized in a perpendicular direction to a thickness direction of the piezoelectric layer 85 (see arrows in Fig. 8A), and power generated as a result can be output to the outside from the pair of electrodes 84a, 84b.

Incidentally, in the vibration power generation element 810 described in Document 1, the power generation unit 83 generates power in response to the oscillation of the cantilever portion 82b. Therefore, the power output from the pair of electrodes 84a, 84b of the vibration power generation element 810 is alternating current power in which a polarity reverses as the cantilever portion 82b oscillates.

However, a load R_{L} connected to the pair of electrodes 84a, 84b of the vibration power generation element 810 typically assumes to be a small electronic component, an LSI, or the like, which requires direct current power. In Document 1, therefore, a vibration power generation device 820 shown in Fig. 8C is constructed using the vibration power generation element 810 described above in order to convert the alternating current power output by the vibration power generation element 810 into direct current power.

In the vibration power generation device 820, a capacitor Cs is connected in parallel with an output of a rectifier D1 constituted by a single-phase full-wave rectifier (a single-phase bridge rectifier circuit) in an output of the vibration power generation element 810, and the load R_{L} is connected between respective ends of the capacitor Cs. As a result, the vibration power generation device 820 is capable of converting the output of the vibration power generation element 810 from alternating current power into direct current power and outputting the direct current power to the load R_{L} side, which is connected to the pair of electrodes 84a, 84b. Note that in the vibration power generation device 820 of Fig. 8C, the vibration power generation element 810 is represented by an equivalent circuit formed from an alternating current power supply Ip, a capacitor Cp connected in parallel to the alternating current power supply Ip, and a resistor Rp connected in parallel to the capacitor Cp.

However, generated power is typically extracted from the vibration power generation element 810 described above in a small amount of approximately µW. When a current output from the vibration power generation element 810 is converted via the rectifier D1 serving as a single-phase full-wave rectifier circuit portion, the vibration power generation device 820 is greatly affected by loss due to a voltage drop occurring in a pn joint portion of a diode constituting the rectifier D1. In the vibration power generation device 820 shown in Fig. 8C in particular, when the output of the vibration power generation element 810 is converted from alternating current power into direct current power, the current from the vibration power generation element 810 is output via two diodes of the rectifier D1 constituted by a single-phase full-wave rectifier. Hence, with the vibration power generation device 820 employing the vibration power generation element 810 described above, a power generation efficiency is poor.

The vibration power generation element 810 is required to be small in size and high in output, making it difficult to increase the output simply by increasing a surface area of the piezoelectric layer 85 of the vibration power generation element 810. Therefore, the configurations of the vibration power generation element 810 and the vibration power generation device 820 described above are insufficient, and further improvement is required.

### Summary of Invention

The present invention has been designed in consideration of the circumstances described above, and an object thereof is to provide a vibration power generation element that can be reduced in size while increasing an output power thereof, and a vibration power generation device including the vibration power generation element.

A vibration power generation element according to the present invention comprises a base substrate and a power generation unit. The base substrate comprises a support portion and a cantilever portion that is supported by the support portion to be free to oscillate. The power generation unit is formed on the cantilever portion and configured to generate alternating current power in response to vibration of the cantilever portion. The power generation unit comprises a lower electrode, a first piezoelectric layer, an intermediate electrode, a second piezoelectric layer, and an upper electrode. The lower electrode is formed on one surface side of the base substrate so as to overlap the cantilever portion. The first piezoelectric layer is formed on an opposite side of the lower electrode from the cantilever portion. The intermediate electrode is formed on an opposite side of the first piezoelectric layer from the lower electrode. The second piezoelectric layer is formed on an opposite side of the intermediate electrode from the first piezoelectric layer. The upper electrode is formed on an opposite side of the second piezoelectric layer from the intermediate electrode.

In an embodiment, the first piezoelectric layer and the second piezoelectric layer are respectively constituted by ferroelectric thin films.

In an embodiment, polarization in the first piezoelectric layer and polarization in the second piezoelectric layer are oriented in an identical direction in a thickness direction of the power generation unit.

In an embodiment, the cantilever portion includes first and second ends, and is supported by the support portion on the first end side such that the second end side is free to oscillate. The power generation unit is disposed on the base substrate on at least the first end side of the cantilever portion.

In an embodiment, the base substrate comprises a frame portion having four sides, first and second sides of which are shorter than two remaining sides, and including the support portion as the first side, and an opening formed between the frame portion and the cantilever portion.

In an embodiment, the support portion supports the cantilever portion on the one surface side of the base substrate such that one surface of the cantilever portion is flush with one surface of the frame portion and the respective surfaces form the surface of the base substrate. The opening is a U-shaped slit.

In an embodiment, the first and second piezoelectric layers are directly joined to respective surfaces of the intermediate electrode.

In an embodiment, the intermediate electrode consists of only one or a plurality of conductive layers.

A vibration power generation device according to the present invention comprises the vibration power generation element described above, and a two-phase full-wave rectifier. The two-phase full-wave rectifier comprises first and second input terminals electrically connected respectively to the upper and lower electrodes, and a common terminal electrically connected to the intermediate electrode, which serves as a common electrode, and the two-phase full-wave rectifier is configured to convert a two-phase alternating current output by the upper electrode and the lower electrode into a direct current.

According to the present invention, a reduction in size and an increase in output power can be achieved.

### Brief Description of Drawings

Preferred embodiments of the invention will now be described in further details. Other features and advantages of the present invention will become better understood with regard to the following detailed description and accompanying drawings where:
Fig. 1 shows a vibration power generation element according to an embodiment, wherein Fig. 1A is a schematic plan view and Fig. 1B is a schematic X-X sectional view of Fig. 1A;
Fig. 2 is a circuit diagram of a vibration power generation device employing the vibration power generation element according to this embodiment;
Fig. 3 is a view illustrating main processes of a manufacturing method of the vibration power generation element according to this embodiment;
Fig. 4 is a view illustrating main processes of the manufacturing method of the vibration power generation element according to this embodiment;
Fig. 5 is a view illustrating main processes of the manufacturing method of the vibration power generation element according to this embodiment;
Fig. 6 is a view illustrating main processes of the manufacturing method of the vibration power generation element according to this embodiment;
Fig. 7 is a view illustrating main processes of the manufacturing method of the vibration power generation element according to this embodiment; and
Fig. 8 shows a conventional vibration power generation element, wherein Fig. 8A is a sectional view, Fig. 8B is a plan view showing main parts of the vibration power generation element, and Fig. 8C is a circuit diagram of a vibration power generation device employing the vibration power generation element.

### Description of Embodiments

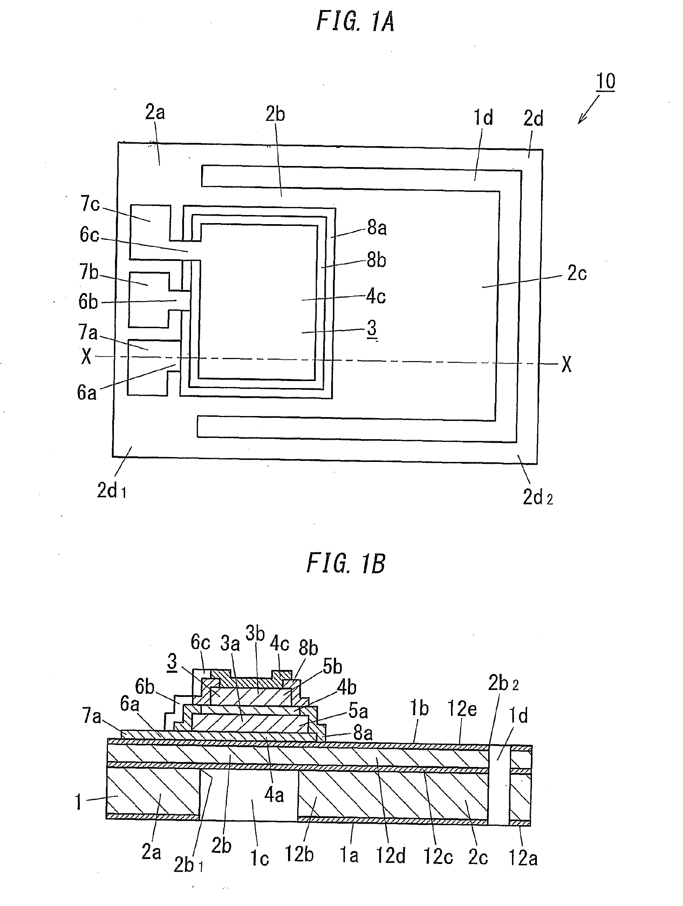

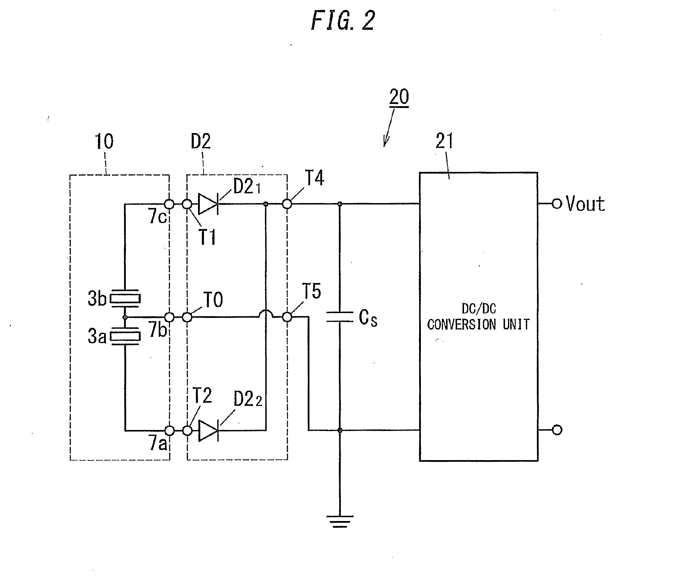

Hereafter, a vibration power generation element according to an embodiment will be described using Fig. 1, and a vibration power generation device 20 employing the vibration power generation element 10 will be described using Fig. 2.

As shown in Fig. 1, the vibration power generation element 10 according to this embodiment includes a base substrate 1 and a power generation unit 3. The base substrate 1 includes a support portion 2a, and a flexible cantilever portion 2b disposed on an inner side of the support portion 2a and supported by the support portion 2a to be free to oscillate. The power generation unit 3 is formed on the cantilever portion 2b on one surface (a first surface) 1b side of the base substrate 1, and configured to generate alternating current power in response to vibration of the cantilever portion 2b.

In the vibration power generation element 10 according to this embodiment in particular, the power generation unit 3 includes a lower electrode 4a, a first piezoelectric layer 5a, an intermediate electrode 4b, a second piezoelectric layer 5b, and an upper electrode 4c. The lower electrode 4a is formed on the first surface 1b side of the base substrate 1 so as to overlap the cantilever portion 2b. The first piezoelectric layer 5a is formed on an opposite side of the lower electrode 4a from the cantilever portion 2b. The intermediate electrode 4b is formed on an opposite side of the first piezoelectric layer 5a from the lower electrode 4a. The second piezoelectric layer 5b is formed on an opposite side of the intermediate electrode 4b from the first piezoelectric layer 5a. The upper electrode 4c is formed on an opposite side of the second piezoelectric layer 5b from the intermediate electrode 4b.

In the example of Figs. 1A and 1B, the cantilever portion 2b includes a first end 2b₁ and a second end 2b₂, and is supported by the support portion 2a on the first end 2b₁ side such that the second end 2b₂ side is free to oscillate. The power generation unit 3 is disposed on the base substrate 1 on at least the first end 2b₁ side of the cantilever portion 2b. In the example shown in the drawings, the power generation unit 3 is disposed on the base substrate 1 on the first end 2b₁ side of the cantilever portion 2b, but the power generation unit according to the present invention is not limited thereto. For example, the power generation unit according to the present invention may be disposed on the base substrate 1 over an entire (first) surface of the cantilever portion 2b and either an entire (first) surface of the support portion 2a or a part of the cantilever portion 2b side. To facilitate deformation of the second end 2b₂ side of the cantilever portion 2b in this case, a dimension of a weight portion 2 described below, which is provided on the second end 2b₂ side of the cantilever portion 2b, in a lengthwise direction of the cantilever portion 2b is preferably shortened in comparison with that shown in Fig. 1B. The support portion 2a is further included in a rectangular frame portion 2d, for example. In other words, the base substrate 1 includes the frame portion 2d and an opening in addition to the cantilever portion 2b. The frame portion 2d has four sides, a first side 2d₁ and a second side 2d₂ of which are shorter than the other two sides, and includes the support portion 2a as the first side 2d₁. Here, the first and second sides are opposing sides. The opening is formed between the frame portion 2d and the cantilever portion 2b. More specifically, the opening is a U-shaped (or C-shaped) slit 1d, whereby the support portion 2a supports the cantilever portion 2b on the first surface 1b side of the base substrate 1 such that one surface (a first surface) of the cantilever portion 2b is flush with one surface (a first surface) of the frame portion 2d and the respective surfaces form the first surface 1b of the base substrate 1.

Further, a lower electrode pad 7a, an intermediate electrode pad 7b, and an upper electrode pad 7c are provided on the first surface of the support portion 2a (the first surface 1b of the base substrate 1), and these electrode pads are electrically connected to the lower electrode 4a, the intermediate electrode 4b, and the upper electrode 4c via connecting wires 6a, 6b, 6c, respectively. The base substrate 1 has the weight portion 2c on a side facing the support portion 2a via the cantilever portion 2b (the second end 2b₂ side of the cantilever portion 2b) when the base substrate 1 is seen from above. The weight portion 2c is disposed so as to be surrounded inside a U-shaped part of the frame portion 2d extending from the support portion 2a via the slit (a through hole) 1d.

The power generation unit 3 is designed such that respective planar sizes of the lower electrode 4a, the first piezoelectric layer 5a, the intermediate electrode 4b, the second piezoelectric layer 5b, and the upper electrode 4c decrease steadily in that order. Further, the power generation unit 3 is disposed on the first surface 1b side of the base substrate 1 and opposite an indentation portion 1c provided on a second surface 1a side of the base substrate 1. Here, when the power generation unit 3 is seen from above, the first piezoelectric layer 5a is positioned on an inner side of an outer peripheral edge of the lower electrode 4a, and the first piezoelectric layer 5a contacts the lower electrode 4a. The intermediate electrode 4b is positioned on an inner side of an outer peripheral edge of the first piezoelectric layer 5a so as to contact the first piezoelectric layer 5a. Further, the second piezoelectric layer 5b is positioned on an inner side of an outer peripheral edge of the intermediate electrode 4b, and the second piezoelectric layer 5b contacts the intermediate electrode 4b. In other words, the first and second piezoelectric layers are directly joined to respective surfaces of the intermediate electrode 4b. The upper electrode 4c is positioned on an inner side of an outer peripheral edge of the second piezoelectric layer 5b so as to contact the second piezoelectric layer 5b.

Furthermore, in the power generation unit 3, a first insulating layer 8a that prevents short-circuits between the connecting wire 6b electrically connected to the intermediate electrode 4b and the lower electrode 4a is formed in a shape that covers respective peripheral portions of the lower electrode 4a and the first piezoelectric layer 5a. The first insulating layer 8a, when seen from above, defines an area of contact between the first piezoelectric layer 5a and the intermediate electrode 4b on the first surface 1b side of the base substrate 1. In other words, when seen from above, the first insulating layer 8a takes the form of a frame that extends around a peripheral portion of the intermediate electrode 4b. Note that the first insulating layer 8a also prevents short-circuits between the connecting wire 6c electrically connected to the upper electrode 4c and the lower electrode 4a.

Similarly, a second insulating layer 8b that prevents short-circuits between the connecting wire 6c electrically connected to the upper electrode 4c and the intermediate electrode 4b is formed on the first insulating layer 8a in a shape that covers respective peripheral portions of the intermediate electrode 4b and the second piezoelectric layer 5b. The second insulating layer 8b, when seen from above, defines an area of contact between the second piezoelectric layer 5b and the upper electrode 4c on the first surface 1b side of the base substrate 1. In other words, when seen from above, the second insulating layer 8b takes the form of a frame that extends around a peripheral portion of the upper electrode 4c.

In this embodiment, the first insulating layer 8a and the second insulating layer 8b of the vibration power generation element 10 are respectively constituted by silicon oxide films, but the insulating layers are not limited to silicon oxide films. For example, the respective insulating films may be silicon nitride films, and may be either single layer or multi-layer films. By forming the first insulating layer 8a and the second insulating layer 8b on the upper side of the oscillating cantilever portion 2b from silicon oxide films or silicon nitride films in this manner, an insulating property and a heat resistance property thereof can be improved in comparison with a case where the first insulating layer 8a and the second insulating layer 8b are formed from resist.

Further, insulating films 12e, 12a constituted by silicon oxide films are formed respectively on the first surface 1b side and the second surface 1a side of the base substrate 1 such that the power generation unit 3 is electrically insulated from the base substrate 1 by the insulating film 12e on the first surface 1b side.

The power generation unit 3 of the vibration power generation element 10 according to this embodiment includes a first piezoelectric conversion unit 3a and a second piezoelectric conversion unit 3b. The first piezoelectric conversion unit 3a is constituted by the lower electrode 4a, the first piezoelectric layer 5a, and the intermediate electrode 4b. The second piezoelectric conversion unit 3b is constituted by the intermediate electrode 4b, the second piezoelectric layer 5b, and the upper electrode 4c. Thus, the first piezoelectric conversion unit 3a and the second piezoelectric conversion unit 3b of the power generation unit 3 respectively receive stress from the vibration of the cantilever portion 2b so as to generate power individually. More specifically, the first piezoelectric conversion unit 3a generates alternating current power when an electric charge bias occurs in the first piezoelectric layer 5a between the lower electrode 4a and the intermediate electrode 4b. Similarly, the second piezoelectric conversion unit 3b generates alternating current power when an electric charge bias occurs in the second piezoelectric layer 5b between the intermediate electrode 4b and the upper electrode 4c.

In the vibration power generation element 10 according to this embodiment, PZT (Pb(Zr, Ti)O₃) using a d₃₁ mode in which a deformation direction and an electric field direction are parallel is employed as a piezoelectric material of the first piezoelectric layer 5a and the second piezoelectric layer 5b. Note that the piezoelectric material of the first piezoelectric layer 5a and second piezoelectric layer 5b of the vibration power generation element 10 is not limited to PZT, and PZT-PMN (Pb(Mn, Nb)O₃), PLZT ((Pb, La)(Zr, Ti)O₃), SBT (SrBi₂Ta₂O₉), and so on, for example, may be used instead. Further, the first piezoelectric layer 5a and the second piezoelectric layer 5b do not necessarily have to be formed from the same material. In other words, surface areas, thicknesses, and materials of the first piezoelectric layer 5a and the second piezoelectric layer 5b may be selected as desired such that an output of the first piezoelectric conversion unit 3a and an output of the second piezoelectric conversion unit 3b are equal.

Furthermore, in the vibration power generation element 10 according to this embodiment, the base substrate 1 is formed using an SOI (Silicon on Insulator) substrate structured such that an embedded oxide film 12c constituted by a silicon oxide film is sandwiched between a monocrystalline silicon substrate 12b and a monocrystalline silicon layer (an active layer) 12d. Note that a substrate in which a surface of the silicon layer 12d is a (100) plane is used as the SOI substrate forming the base substrate 1.

Moreover, since an SOI substrate is used as the base substrate 1 in the vibration power generation element 10 according to this embodiment, the embedded oxide film 12c of the SOI substrate can be used as an etching stopper layer when forming the cantilever portion 2b during a manufacturing process to be described below. As a result, a high degree of precision can be achieved in the thickness of the cantilever portion 2b, and an improvement in reliability and a reduction in cost can be achieved in the vibration power generation element 10. Note that the base substrate 1 is not limited to an SOI substrate, and a monocrystalline silicon substrate or the like, for example, may be used instead.

Further, the lower electrode 4a, the intermediate electrode 4b, and the upper electrode 4c are preferably constituted respectively only by one or a plurality of conductive layers. In the vibration power generation element 10 according to this embodiment, the lower electrode 4a is formed from a Pt film. The intermediate electrode 4b, meanwhile, is formed from a laminated film including a Ti film and an Au film. Further, the upper electrode 4c is formed from a laminated film including a Ti film and a Pt film. There are no particular limitations on materials and layer structures of the lower electrode 4a, the intermediate electrode 4b, and the upper electrode 4c of the vibration power generation element 10, and the lower electrode 4a, the intermediate electrode 4b, and the upper electrode 4c may be formed respectively with either a single layer structure or a multi-layer structure. Au, Al, Ir, or the like, for example, may be employed as an electrode material of the lower electrode 4a and the upper electrode 4c, while Mo, Al, Pt, In, or the like, for example, may be employed as the material of the intermediate electrode 4b.

In the vibration power generation element 10 according to this embodiment, a thickness of the lower electrode 4a is set at 100 nm, while a thickness of the first piezoelectric layer 5a is set at 600 nm. Further, a thickness of the second piezoelectric layer 5b, which has a smaller surface area than the first piezoelectric layer 5a when seen from above and generates less stress than the first piezoelectric layer 5a in response to the vibration of the cantilever portion 2b, is set to be greater than the thickness of the first piezoelectric layer 5a such that a power generation output thereof is equal to the power generation output of the first piezoelectric layer 5a. In the vibration power generation element 10 according to this embodiment, a thickness of the intermediate electrode 4b is set at 100 nm and a thickness of the upper electrode 4c is set at 100 nm. Note that the respective thicknesses of the lower electrode 4a, the intermediate electrode 4b, the upper electrode 4c, the first piezoelectric layer 5a, and the second piezoelectric layer 5b of the vibration power generation element 10 are not limited to the thicknesses described above, and may be set as desired.

In the vibration power generation element 10 according to this embodiment, the cantilever portion 2b is rectangular when seen from above, but the cantilever portion 2b is not limited thereto, and may take a trapezoidal shape having a width dimension that decreases gradually from the support portion 2a toward the weight portion 2c, for example.

When the vibration power generation element 10 according to this embodiment is seen from above, the first piezoelectric layer 5a is positioned on the inner side of the outer peripheral edge of the lower electrode 4a, and the intermediate electrode 4b is positioned on the inner side of the outer peripheral edge of the first piezoelectric layer 5a. Therefore, in comparison with a case where the lower electrode 4a, the first piezoelectric layer 5a, and the intermediate electrode 4b have identical planar sizes, a step in a part serving as a base of the connecting wire 6b can be reduced. Similarly, when the vibration power generation element 10 is seen from above, the second piezoelectric layer 5b is positioned on the inner side of the outer peripheral edge of the intermediate electrode 4b and the upper electrode 4c is positioned on the inner side of the outer peripheral edge of the second piezoelectric layer 5b, and therefore, in comparison with a case where the intermediate electrode 4b, the second piezoelectric layer 5b, and the upper electrode 4c have identical planar sizes, a step in a part serving as a base of the connecting wire 6c can be reduced.

In the vibration power generation element 10, to ensure that substantially equal amounts of power are output respectively from the first piezoelectric layer 5a and the second piezoelectric layer 5;b, the second piezoelectric layer 5b, which has a smaller surface area than the first piezoelectric layer 5a when seen from above, may be formed to have a greater thickness than the first piezoelectric layer 5a. In this case, the steps in the parts forming the bases of the connecting wire 6b formed on the first piezoelectric layer 5a and the connecting wire 6b formed on the second piezoelectric layer 5b can be reduced, enabling an improvement in the reliability of the vibration power generation element 10.

Further, in the vibration power generation element 10, the first insulating layer 8a for preventing short-circuits between the lower electrode 4a and the intermediate electrode 4b and upper electrode 4c may be extended onto the support portion 2a on the first surface 1b side of the base substrate 1. In other words, all sites of the connecting wire 6b between the intermediate electrode 4b and the intermediate electrode pad 7b electrically connected to the intermediate electrode 4b may be formed on the first insulating layer 8a while the intermediate electrode pad 7b may be formed on a flat site of the first insulating layer 8a (not shown in the drawings). In so doing, the step in the part serving as the base of the connecting wire 6b of the vibration power generation element 10 can be reduced, and as a result, the likelihood of disconnection of the connecting wire 6b electrically connecting the lower electrode 4a to the intermediate electrode pad 7b can be reduced while increasing the film thickness of the first piezoelectric layer 5a.

Similarly, all sites of the connecting wire 6c between the upper electrode 4c and the upper electrode pad 7c electrically connected to the upper electrode 4c may be formed on the second insulating layer 8b while the upper electrode pad 7c may be formed on a flat site of the second insulating layer 8b (not shown in the drawings). In so doing, the step in the part serving as the base of the connecting wire 6c of the vibration power generation element 10 can be reduced, and as a result, the likelihood of disconnection of the connecting wire 6c electrically connecting the intermediate electrode 4b to the upper electrode pad 7c can be reduced while increasing the film thickness of the second piezoelectric layer 5b.

In the vibration power generation element 10 according to this embodiment, the power generated by the first piezoelectric conversion unit 3a can be output using the lower electrode 4a and the intermediate electrode 4b. Similarly, in the vibration power generation element 10 according to this embodiment, the power generated by the second piezoelectric conversion unit 3b can be output using the intermediate electrode 4b and the upper electrode 4c.

Here, the vibration power generation element 10 according to this embodiment is provided with a two-phase full-wave rectifier D2, which together constitute the vibration power generation device 20. The rectifier D2 includes first and second input terminals T1 and T2 electrically connected respectively to the upper and lower electrodes 4c and 4a, and a common terminal T0 electrically connected to the intermediate electrode 4b, which serves as a common electrode. The rectifier D2 is configured to convert a two-phase alternating current output by the lower electrode 4a and the upper electrode 4c into a direct current. More specifically, as shown in Fig. 2, the intermediate electrode pad 7b is electrically connected to the intermediate electrode 4b of the vibration power generation element 10 and also electrically connected to the common terminal T0. The lower electrode pad 7a is electrically connected to the lower electrode 4a and also electrically connected to the second input terminal T2. The upper electrode pad 7c is electrically connected to the upper electrode 4c and also electrically connected to the first input terminal T1. As a result, the vibration power generation element 10 is connected to the rectifier D2. The rectifier D also includes a first output terminal T4 and a second output terminal T5, a first diode D2₁ connected between the first input terminal T1 and the first output terminal T4, and a second diode D2₂ connected between the second input terminal T2 and the first output terminal T4. The second output terminal T5 is electrically connected to the common terminal T0. In the example of Fig. 2, an anode and a cathode of the first diode D2₁ are respectively connected to the first input terminal T1 and the first output terminal T4, while an anode and a cathode of the second diode D2₂ are respectively connected to the second input terminal T2 and the first output terminal T4. Further, a capacitor Cs is connected between the respective output terminals of the rectifier D2. In the vibration power generation device 20, a DC/DC conversion unit 21 is provided between the capacitor Cs and a load (not shown) connected to the vibration power generation device 20, and a voltage supplied to the load side is increased or reduced appropriately in accordance with the load.

In the vibration power generation device 20 including the vibration power generation element 10 according to this embodiment, in contrast to the vibration power generation device 820 shown in Fig. 8C and described above, a current is output from the vibration power generation element 10 through a single diode of the rectifier D2 when converting the output of the vibration power generation element 10 from alternating current power into direct current power. Hence, in the vibration power generation device 20 including the vibration power generation element 10 according to this embodiment, loss occurring in the diode of the rectifier can be reduced in comparison with the vibration power generation device 820 shown in Fig. 8C, and as a result, a power generation efficiency can be improved. Further, since the intermediate electrode 4b is constituted only by one or a plurality of conductive layers and the first and second piezoelectric layers are joined directly to the respective surfaces of the intermediate electrode, a distance between the first and second piezoelectric layers can be minimized, enabling minimization of a thickness dimension of the vibration power generation element 10.

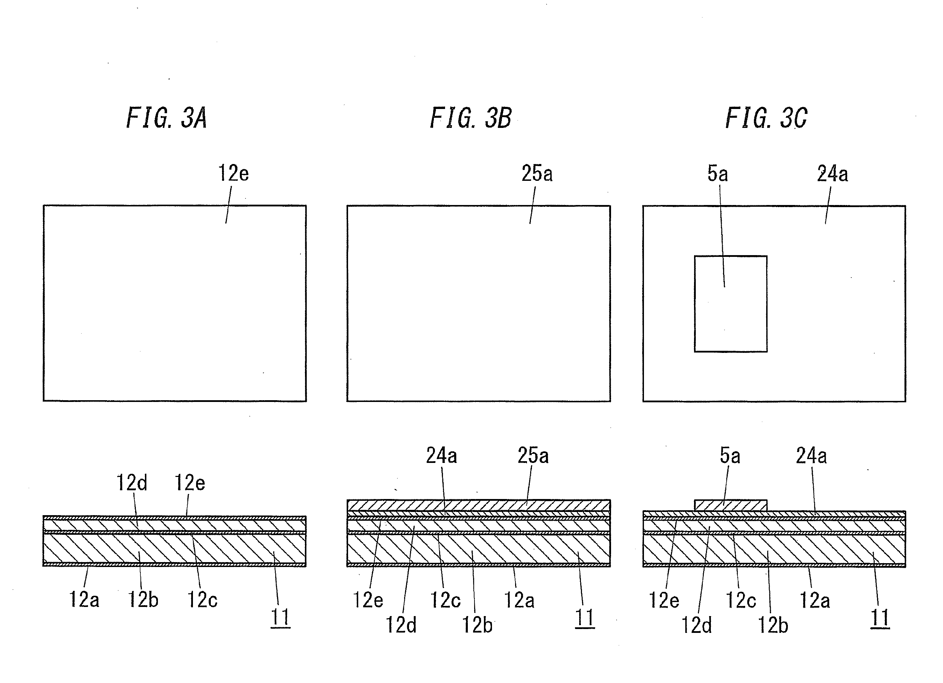

A method of manufacturing the vibration power generation element 10 according to this embodiment will be described below with reference to Figs. 3 to 7. In the manufacturing processes shown in the respective drawings, a plan view is shown on an upper side and a schematic sectional view of main parts is shown on a lower side.

First, an insulating film forming process (see Fig. 3A) is performed using a thermal oxidation method or the like to form the insulating films 12e, 12a, which are constituted by silicon oxide films, respectively on one surface (a first surface) side and another surface (a second surface) side of an element forming substrate 11 constituted by the aforesaid SOI substrate used as the base substrate 1. As a result, the insulating film 12e and the insulating film 12a are provided respectively on the first surface 1b side and the second surface 1a side of the base substrate 1 formed using the element forming substrate 11. Note that the element forming substrate 11 constituted by an SOI substrate is structured such that the embedded oxide film 12c constituted by a silicon oxide film is sandwiched between the monocrystalline silicon substrate 12b and the monocrystalline silicon layer 12d.

A first metal film forming process is then performed using a sputtering method, a CVD method, or the like, for example, to form a first metal film 24a constituted by a Pt layer over the entire surface of the first surface side of the element forming substrate 11 as a foundation for the lower electrode 4a, the connecting wire 6a, and the lower electrode pad 7a. Next, a piezoelectric film forming process is performed using a sputtering method, a CVD method, a sol-gel method, a transfer method to be described below, or the like, for example, to form a first piezoelectric film (a PZT film or the like, for example) 25a over the entire surface of the first surface side of the element forming substrate 11 as a foundation for the first piezoelectric layer 5a formed from a piezoelectric material (PZT or the like, for example) (see Fig. 3B).

In the vibration power generation element 10 according to this embodiment, the first piezoelectric layer 5a is formed on the lower electrode 4a, but a seed layer that serves as a base during film formation of the first piezoelectric layer 5a may be interposed between the first piezoelectric layer 5a and the lower electrode 4a in order to improve a crystallinity of the first piezoelectric layer 5a. A conductive oxide material such as PLT ((Pb, La)TiO₃), PTO (PbTiO₃), or SRO (SrRuO₃), for example, may be used as a material of the seed layer.

Further, the first metal film 24a is not limited to a Pt film, and may be an Al film or an Al-Si film, for example. Alternatively, the first metal film 24a may be configured to include an Au film and a Ti film that is interposed between the Au film and the insulating film 12e as an adhesive film for improving an adhesion property. Here, the material of the adhesive film, which is not shown in the drawings, is not limited to Ti, and Cr, Nb, Zr, TiN, TaN, and so on, for example, may be used instead.

Following the piezoelectric film forming process, a piezoelectric film patterning process is performed to form the first piezoelectric layer 5a from a part of the first piezoelectric film 25a by patterning the first piezoelectric film 25a into a predetermined shape using a photolithography technique and an etching technique (see Fig. 3C).

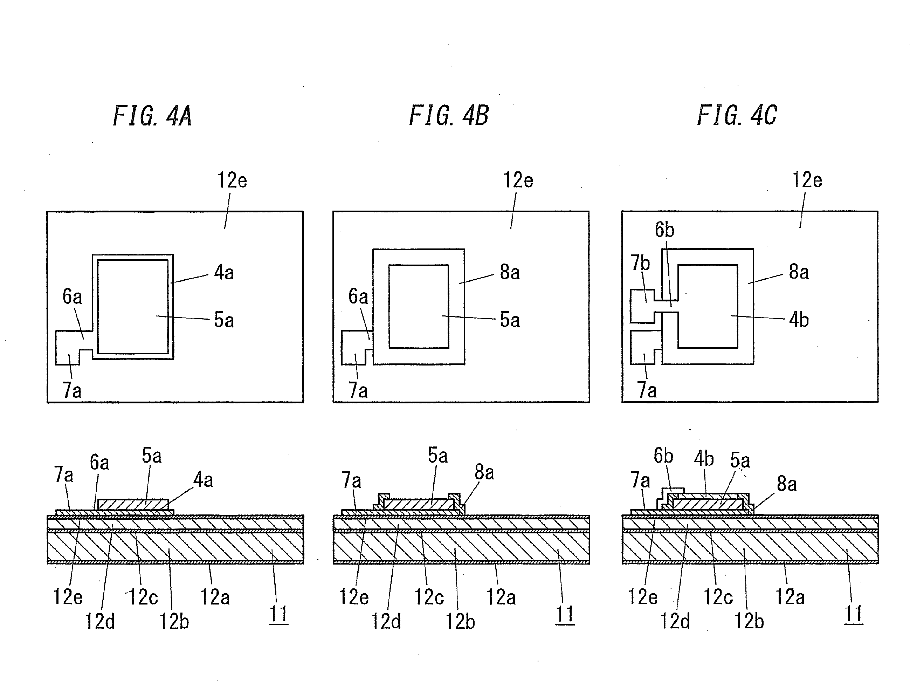

Next, a metal film patterning process is performed to form the lower electrode 4a, the connecting wire 6a, and the lower electrode pad 7a from respective parts of the first metal film 24a by patterning the first metal film 24a into a predetermined shape using a photolithography technique and an etching technique (see Fig. 4A). Note that in the manufacturing method of the vibration power generation element 10 according to this embodiment, the connecting wire 6a and the lower electrode pad 7a are formed at the same time as the lower electrode 4a by patterning the first metal film 24a in the metal film patterning process. Here, instead of forming all of the lower electrode 4a, the connecting wire 6a, and the lower electrode pad 7a simultaneously, the lower electrode 4a may be formed alone by patterning the first metal film 24a in the metal film patterning process. In this case, a separate wire forming process for forming the connecting wire 6a and the lower electrode pad 7a may be performed after forming the lower electrode 4a. Similarly, a connecting wire forming process for forming the connecting wire 6a and a lower electrode pad forming process for forming the lower electrode pad 7a may be provided separately. To etch the first metal film 24a, a RIE method, an ion milling method, or the like, for example, may be employed as desired.

After forming the lower electrode 4a, the connecting wire 6a, and the lower electrode pad 7a in the metal film patterning process, a first insulating layer forming process is performed to form the first insulating layer 8a on the first surface side of the element forming substrate 11 (see Fig. 4B). In the first insulating layer forming process, a resist film is applied to the first surface side of the element forming substrate 11 on which the first piezoelectric layer 5a is formed, whereupon the resist film is patterned using a photolithography technique. Next, an insulating film is deposited over the entire surface of the first surface side of the element forming substrate 11 using a CVD method or the like, whereupon the first insulating layer 8a is formed using a lift-off method in which the resist film is peeled away. The patterning performed in the first insulating layer forming process to form the first insulating layer 8a is not limited to the lift-off method, and may be performed using a photolithography technique and an etching technique instead.

Next, in an intermediate electrode forming process for forming the intermediate electrode 4b, a resist film is applied to the first surface side of the element forming substrate 11 on which the first insulating layer 8a is formed, whereupon the resist film is patterned using a photolithography technique. Next, an intermediate electrode forming process is performed to form the connecting wire 6b and the intermediate electrode pad 7b together with the intermediate electrode 4b by vapor-depositing a metal film and peeling away the resist film using the lift-off method (see Fig. 4C). Note that the intermediate electrode 4b may be formed at the same time as the connecting wire 6b and the intermediate electrode pad 7b in an intermediate electrode forming process performed using a thin film formation technique such as an EB vapor deposition method, a sputtering method, or a CVD method, a photolithography technique, and an etching technique. Further, in the method of manufacturing the vibration power generation element 10 according to this embodiment, the connecting wire 6b and the intermediate electrode pad 7b are formed together with the intermediate electrode 4b in the intermediate electrode forming process, but instead, an intermediate electrode forming process and a wire forming process may be performed separately. Moreover, the wire forming process may be divided into a connecting wire forming process for forming the connecting wire 6b and an intermediate electrode pad forming process for forming the intermediate electrode pad 7b.

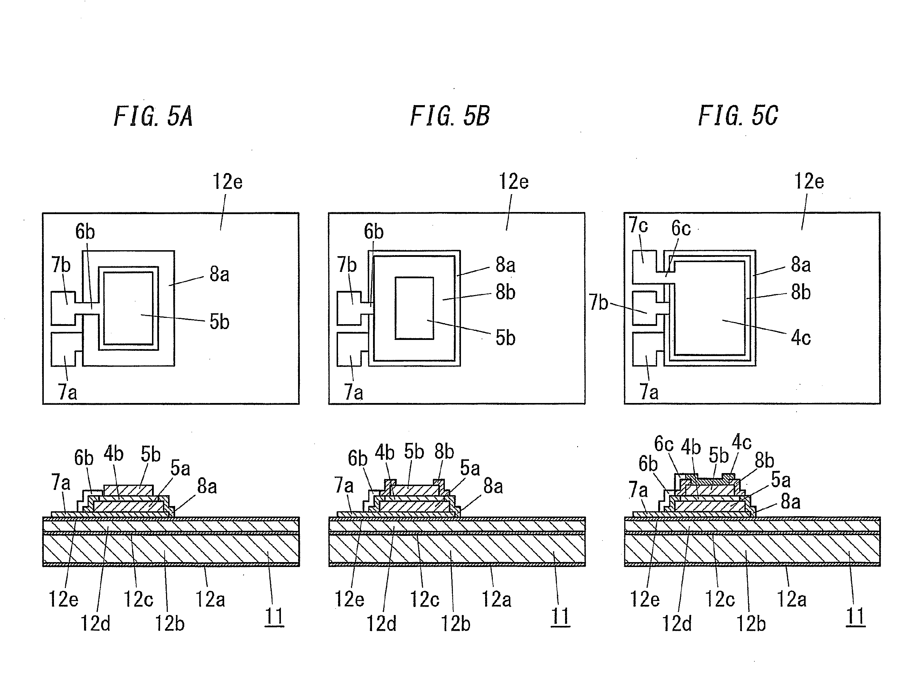

After forming the intermediate electrode 4b, the connecting wire 6b, and the intermediate electrode pad 7b as described above, a second piezoelectric layer forming process is performed to form the second piezoelectric layer 5b from a piezoelectric material (PZT or the like, for example) on the intermediate electrode 4b of the element forming substrate 11 (see Fig. 5A). The second piezoelectric layer 5b may be formed using a photolithography technique and an etching technique after forming a piezoelectric film using a sputtering method, a CVD method, a sol-gel method, or a transfer method, for example.

Here, to form the second piezoelectric layer 5b using the transfer method, a second piezoelectric film constituted by a ferroelectric thin film is deposited in advance on one surface of a second piezoelectric film forming substrate, not shown in the drawings, using a sputtering method, a CVD method, a sol-gel method, or the like. Next, in a condition where the second piezoelectric film on the second piezoelectric film forming substrate opposes the intermediate electrode 4b formed on the element forming substrate 11, a laser beam is emitted from another surface side of the translucent second piezoelectric film forming substrate. The laser beam is emitted so as to be absorbed by an interface between the second piezoelectric film forming substrate and the second piezoelectric film. As a result, a part of the second piezoelectric film is peeled away from the second piezoelectric film forming substrate. The peeled part of the second piezoelectric film is transferred onto the intermediate electrode 4b side of the element forming substrate 11 to form the second piezoelectric layer 5b. By controlling a region that is irradiated with the laser beam, the second piezoelectric film can be transferred onto the. intermediate electrode 4d so as to have a smaller outer form than the intermediate electrode 4d when seen from above.

A substrate that has a smaller lattice constant difference relative to the second piezoelectric film forming the foundation of the second piezoelectric layer 5b than the base substrate 1, and therefore exhibits a favorable lattice matching property, is preferably used as the second piezoelectric film forming substrate. For example, when PZT is used as the material of the second piezoelectric film, a monocrystalline MgO substrate, a monocrystalline STO (SrTiO₃) substrate, or the like may be used as the second piezoelectric film forming substrate. Further, the laser beam used to transfer a part of the second piezoelectric film from the second piezoelectric film forming substrate may be emitted from a KrF excimer laser, for example. Furthermore, a seed layer made of PLT, PTO, SRO, or the like may be provided between the second piezoelectric film forming substrate and the second piezoelectric film to control a crystal orientation of the second piezoelectric film. The seed layer may be used as a sacrificial layer that is removed after absorbing the laser beam when a part of the second piezoelectric film is peeled away during transfer of the second piezoelectric film. When an unnecessary piece of the second piezoelectric film forming substrate adheres to the element forming substrate 11 side during transfer of the second piezoelectric film, the piece may be removed using an appropriate etchant.

By employing this transfer method in which the piezoelectric layer is formed by transferring a separately formed piezoelectric film, a time required to manufacture the vibration power generation element 10 can be shortened. More specifically, in contrast to a method of manufacturing the vibration power generation element 10 in which the first piezoelectric layer 5a and the second piezoelectric layer 5b are deposited sequentially, the time-consuming piezoelectric film forming processes for forming piezoelectric films can be performed separately and in parallel for the first piezoelectric layer 5a and the second piezoelectric layer 5b.

Following the second piezoelectric layer forming process using the transfer method described above, a second insulating layer forming process is performed to form the second insulating layer 8b, from which a part of the second piezoelectric layer 5b is exposed, on the first surface side of the element forming substrate 11 (see Fig. 5B). In the second insulating layer forming process, a resist film is applied to the first surface side of the element forming substrate 11 on which the second piezoelectric layer 5b is formed, whereupon the resist film is patterned using a photolithography technique. Next, an insulating film is deposited over the entire surface of the first surface side of the element forming substrate 11 using a CVD method or the like, whereupon the second insulating layer 8b is formed by peeling away the resist film using the lift-off method. The patterning performed in the second insulating layer forming process to form the second insulating layer 8b is not limited to the lift-off method, and may be performed using a photolithography technique and an etching technique instead.

Next, the upper electrode 4c is formed by applying a resist film to the first surface side of the element forming substrate 11 on which the second insulating layer 8b covering the second piezoelectric layer 5b is formed, then patterning the resist film using a photolithography technique, and then vapor-depositing a metal film and peeling away the resist film, thereby forming the connecting wire 6c and the upper electrode pad 7c together with the upper electrode 4c (see Fig. 5C). The upper electrode 4c is formed at the same time as the connecting wire 6c and the upper electrode pad 7c in an upper electrode forming process performed using a thin film formation technique such as an EB vapor deposition method, a sputtering method, or a CVD method, a photolithography technique, and an etching technique.

In the method of manufacturing the vibration power generation element 10 according to this embodiment, the connecting wire 6c and the upper electrode pad 7c are formed together with the upper electrode 4c in the upper electrode forming process, but instead, an upper electrode forming process and a wire forming process may be performed separately. Further, the wire forming process may be divided into a connecting wire forming process for forming the connecting wire 6c and an upper electrode pad forming process for forming the upper electrode pad 7c.

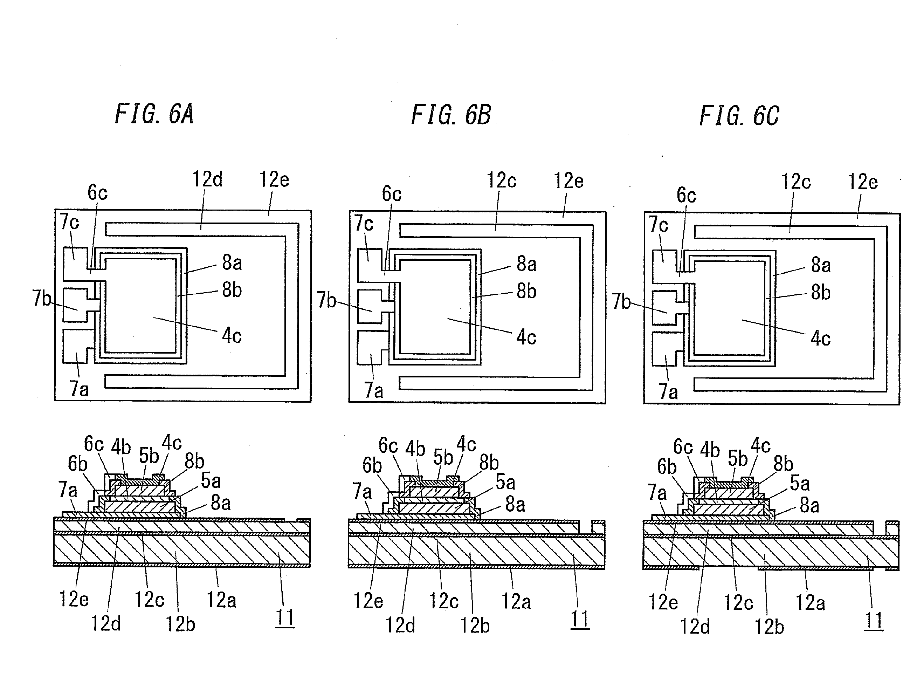

Next, an element forming substrate fashioning process is performed to form the base substrate 1 including the support portion 2a and the cantilever portion 2b by fashioning the element forming substrate 11 using a photolithography technique, an etching technique, and so on. Using a photolithography technique, an etching technique, and so on, parts of the insulating film 12e other than sites forming the support portion 2a, the cantilever portion 2b, and the weight portion 2c are etched from the first surface side of the element forming substrate 11 by BHF or the like. Thus, a surface insulating film removal process is performed to expose the silicon layer 12d of the element forming substrate 11 (see Fig. 6A).

Next, parts of the silicon layer 12d in the sites of the first surface side of the element forming substrate 11 from which the insulating film 12e was removed are removed by etching using an RIE method. Thus, a front surface groove forming process is performed to form a front surface groove that will serve as a part of the slit 1d by exposing the embedded oxide film 12c (see Fig. 6B).

Next, using a photolithography technique, an etching technique, and so on, parts of the insulating film 12a other than sites forming the support portion 2a, the cantilever portion 2b, and the weight portion 2c are etched from the second surface side of the element forming substrate 11 by BHF or the like. As a result, a part of the insulating film 12a is removed such that the monocrystalline silicon substrate 12b is exposed (see Fig. 6C).

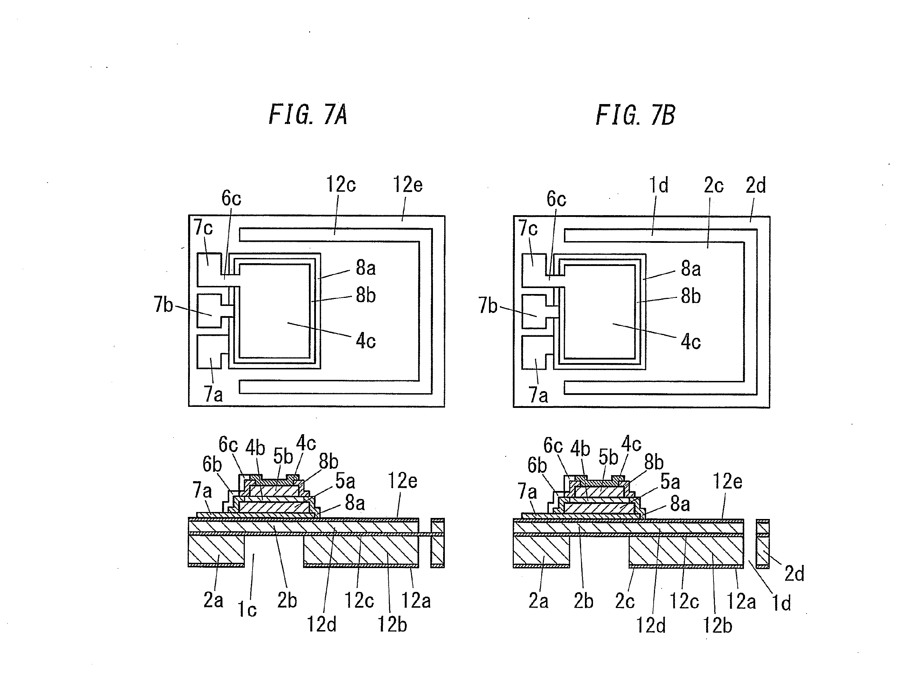

After partially removing the insulating film 12a, the element forming substrate 11 is etched in the sites on the second surface side of the element forming substrate 11 from which the insulating film 12a was removed to a predetermined depth extending to the embedded oxide film 12c using a Deep-RIE method. Thus, a rear surface groove forming process is performed to form a rear surface groove that will serve as a part of the slit 1d by exposing the embedded oxide film 12c on the second surface side of the element forming substrate 11 (see Fig. 7A). In the rear surface groove forming process, the indentation portion 1c is formed on the second surface side of the element forming substrate 11 at the same time as the rear surface groove.

Next, an oxide film etching process is performed to remove an unnecessary part of the embedded oxide film 12c through etching using a RIE method, whereby the slit 1d is formed to connect the front surface groove to the rear surface groove (see Fig. 7B). As a result, the vibration power generation element 10 can be manufactured such that the weight portion 2c is formed together with the cantilever portion 2b. By forming the slit 1d in the vibration power generation element 10 according to this embodiment, the weight portion 2c is provided on the opposite side of the cantilever portion 2b to the support portion 2a, and the weight portion 2c is disposed so as to be surrounded by the inner side of the U-shaped (or C-shaped) frame portion 2d extending from the support portion 2a via the slit 1d.

In the vibration power generation element 10 according to this embodiment, the weight portion 2c is provided on the opposite side of the cantilever portion 2b to the support portion 2a, and therefore a power generation amount can be increased in comparison with a case where the weight portion 2c is not provided. Note that as long as the vibration power generation element 10 includes the cantilever portion 2b that is supported by the support portion 2a to be free to oscillate, the weight portion 2c and the frame portion 2d do not necessarily have to be formed. Hence, as long as the vibration power generation element 10 includes the cantilever portion 2b, the oxide film etching process for forming the slit 1d may be omitted. Further, by completing the manufacturing processes of the vibration power generation element 10 up to the element forming substrate fashioning process at a wafer level and then performing a dicing process to divide individual vibration power generation elements 10, a plurality of vibration power generation elements 10 can be formed with a high degree of productivity.

Note that although the vibration power generation element 10 shown in Fig. 1 is basically constituted by the base substrate 1 and the power generation unit 3, a first cover substrate, not shown in the drawings, fixed to the support portion 2a and the frame portion 2d may be provided on the first surface 1b side of the base substrate 1, and a second cover substrate, not shown in the drawings, fixed to the support portion 2a and the frame portion 2d may be provided on the second surface 1a side of the base substrate 1.

For example, a glass substrate or a silicon substrate including a recess that forms a displacement space in which the cantilever portion 2b and the weight portion 2c oscillate relative to the base substrate 1 may be used on the first surface 1b side of the base substrate 1 as the first cover substrate.

If desired, the first cover substrate may include communicating electrodes joined respectively to the lower electrode pad 7a, the intermediate electrode pad 7b, and the upper electrode pad 7c on the base substrate 1 to be capable of output to the outside.

Further, a glass substrate or a silicon substrate including a recess that forms the displacement space in which the cantilever portion 2b and the weight portion 2c oscillate relative to the base substrate 1 may be used on the second surface 1a side of the base substrate 1 as the second cover substrate. Here, the base substrate 1 may be joined to the first and second cover substrates by an ambient temperature joining method, a resin joining method using epoxy resin or the like, an anode joining method, or the like, for example.

To manufacture the vibration power generation element 10 including the first and second cover substrates, after forming the base substrate 1, a cover joining process may be performed to join the respective cover substrates, and after completing the manufacturing processes up to the cover joining process at the wafer level, individual vibration power generation elements 10 can be obtained by performing a dicing process.

In the vibration power generation element 10 according to this embodiment, described above, polarization processing can be performed on the first piezoelectric layer 5a employing a ferroelectric thin film by applying a high electric field between the lower electrode 4a and the intermediate electrode 4b. Further, in the vibration power generation element 10 according to this embodiment, when deviation occurs in the orientation of the polarization in the first piezoelectric layer 5a employing a ferroelectric thin film, the orientation of the polarization in the first piezoelectric layer 5a can be aligned by the polarization processing. Similarly, in the vibration power generation element 10 according to this embodiment, when deviation occurs between the orientation of the polarization in the first piezoelectric layer 5a and an oscillation direction of the cantilever portion 2b, the polarization orientation of the first piezoelectric layer 5a can be aligned with the oscillation direction by the polarization processing. Therefore, with the vibration power generation element 10 according to this embodiment, a reduction in power generation efficiency due to deviation in the polarization orientation of the first piezoelectric layer 5a or deviation between the polarization orientation of the first piezoelectric layer 5a and the oscillation direction of the cantilever portion 2b can be suppressed.

Similarly, in the vibration power generation element 10 according to this embodiment, polarization processing can be performed on the second piezoelectric layer 5b employing a ferroelectric thin film by applying a high electric field between the intermediate electrode 4b and the upper electrode 4c. Further, in the vibration power generation element 10 according to this embodiment, even when deviation occurs in the orientation of the polarization in the second piezoelectric layer 5b employing a ferroelectric thin film, the orientation of the polarization in the second piezoelectric layer 5b can be aligned by the polarization processing. Similarly, in the vibration power generation element 10 according to this embodiment, even when deviation occurs between the orientation of the polarization in the second piezoelectric layer 5b and the oscillation direction of the cantilever portion 2b, the polarization orientation of the second piezoelectric layer 5b can be aligned with the oscillation direction by the polarization processing. Therefore, with the vibration power generation element 10 according to this embodiment, a reduction in power generation efficiency due to deviation between the orientation of the polarization in the second piezoelectric layer 5b and the oscillation direction of the cantilever portion 2b can be suppressed.

Moreover, in the vibration power generation element 10 according to this embodiment, polarization processing can be performed on the first piezoelectric layer 5a employing a ferroelectric thin film and the second piezoelectric layer 5b employing a ferroelectric thin film by applying high electric fields between the lower electrode 4a and the intermediate electrode 4b and between the intermediate electrode 4b and the upper electrode 4c, respectively. As a result, the orientation of the polarization in the first piezoelectric layer 5a and the orientation of the polarization in the second piezoelectric layer 5b can be aligned in an identical direction in the thickness direction of the power generation unit 3. By aligning the polarization orientations of the first piezoelectric layer 5a and the second piezoelectric layer 5b in the vibration power generation element 10 according to this embodiment, the vibration power generation device 20 including the vibration power generation element 10 can convert the alternating current power, which is output from the vibration power generation element 10 when the cantilever portion 2b oscillates, into direct current power.

In the vibration power generation element 10 according to this embodiment, thus formed, the intermediate electrode 4b is sandwiched between the first piezoelectric layer 5a and the second piezoelectric layer 5b, and therefore stress acting on the first piezoelectric layer 5a and the second piezoelectric layer 5b when the cantilever portion 2b oscillates can be mitigated. Hence, with the vibration power generation element 10 according to this embodiment, cracks and the like can be prevented from forming in the first piezoelectric layer 5a and the second piezoelectric layer 5b as the cantilever portion 2b oscillates, and a total film thickness of the first piezoelectric layer 5a and the second piezoelectric layer 5b serving as the piezoelectric layers of the power generation unit 3 can be increased, leading to an increase in output power. In other words, the vibration power generation element 10 according to this embodiment can be reduced in size while increasing the output power thereof.

Although the present invention has been described with reference to certain preferred embodiments, numerous modifications and variations can be made by those skilled in the art without departing from the true spirit and scope of this invention, namely claims.

## Claims

1. A vibration power generation element comprising:
a base substrate comprising a support portion and a cantilever portion that is supported by the support portion to be free to oscillate; and
a power generation unit that is formed on the cantilever portion and configured to generate alternating current power in response to vibration of the cantilever portion,
wherein the power generation unit comprises:
a lower electrode formed on one surface side of the base substrate so as to overlap the cantilever portion;
a first piezoelectric layer formed on an opposite side of the lower electrode from the cantilever portion;
an intermediate electrode formed on an opposite side of the first piezoelectric layer from the lower electrode;
a second piezoelectric layer formed on an opposite side of the intermediate electrode from the first piezoelectric layer; and
an upper electrode formed on an opposite side of the second piezoelectric layer from the intermediate electrode.

2. The vibration power generation of claim 1, wherein the first piezoelectric layer and the second piezoelectric layer are respectively constituted by ferroelectric thin films.

3. The vibration power generation element of claim 1, wherein polarization in the first piezoelectric layer and polarization in the second piezoelectric layer are oriented in an identical direction in a thickness direction of the power generation unit.

4. The vibration power generation element of claim 2, wherein polarization in the first piezoelectric layer and polarization in the second piezoelectric layer are oriented in an identical direction in a thickness direction of the power generation unit.

5. The vibration power generation element of claim 1, wherein the cantilever portion includes first and second ends, and is supported by the support portion on the first end side such that the second end side is free to oscillate, and
the power generation unit is disposed on the base substrate on at least the first end side of the cantilever portion.

6. The vibration power generation element of claim 5, wherein the base substrate comprises:
a frame portion having four sides, first and second sides of which are shorter than two remaining sides, and including the support portion as the first side; and
an opening formed between the frame portion and the cantilever portion.

7. The vibration power generation element of claim 6, wherein the support portion supports the cantilever portion on the one surface side of the base substrate such that one surface of the cantilever portion is flush with one surface of the frame portion and the respective surfaces form the surface of the base substrate, and
the opening is a U-shaped slit.

8. The vibration power generation element of claim 1, wherein the first and second piezoelectric layers are directly joined to respective surfaces of the intermediate electrode.

9. The vibration power generation element of claim 1, wherein the intermediate electrode consists of only one or a plurality of conductive layers.

10. A vibration power generation device comprising:
the vibration power generation element of any one of claims 1 to 9; and
a two-phase full-wave rectifier that comprises first and second input terminals electrically connected respectively to the upper and lower electrodes, and a common terminal electrically connected to the intermediate electrode, which serves as a common electrode, the two-phase full-wave rectifier being configured to convert a two-phase alternating current output by the upper electrode and the lower electrode into a direct current.
